# EUROPEAN PATENT APPLICATION

(11) **EP 2 081 226 A1**
(43) Date of publication of application: **22.07.2009**
(21) Application number: 08165341.2
(22) Date of filing: 29.09.2008
(51) Int. Cl.: H01L 25/065

(54) **Multi-channel stackable semiconductor device and method for fabricating the same, and stacking substrate applied to the semiconductor device**

(30) Priority: 10.01.2008 TW 97100949
(71) Applicant: Abounion Technology Corporation, Hsinchu (TW)
(72) Inventor: Chen, Wen-Chuang, Hsinchu (TW)
(74) Representative: Skone James, Robert Edmund

(57) **Abstract**

A multi-channel stackable semiconductor device and a method for fabricating the same, and a stacking substrate (10) applied to the semiconductor device are provided. A plurality of stacking substrates and package members having known good dies are provided. Each stacking substrate (10) includes a first surface, an opposite second surface, a plurality of electrical bond pads (12) and ball pads (13) formed on the first surface, and a plurality of electrical terminals (13') formed on the second surface. The ball pads (13) are electrically connected to the electrical terminals (13') by conductive structures formed in the stacking substrate. A plurality of corresponding connection paths are provided between at least one of the electrical bond pads and at least some of the ball pads, so as to allow each of the electrical bond pads to be selectively electrically connected to the ball pads. A package member is mounted on and electrically connected to each stacking substrate.

## Description

### BACKGROUND OF THE INVENTION

### 1. Field of the Invention

The present invention generally relates to semiconductor structures and methods for fabricating the same, and more specifically, to a multi-channel stackable semiconductor device and a method for fabricating the same, and a stacking substrate applied to the semiconductor device.

### 2. Description of Related Art

Due to increasing demands of electronic products on miniaturization and high-speed operation, also in order to enhance performance and capacity of a single semiconductor package structure for use with miniaturized electronic products, the semiconductor industry has developed designs of integrating a plurality of semiconductor packages to a circuit board for creating devices with special electronic functions, and such designs are called modulization.

In a common modulized semiconductor device, a plurality of semiconductor packages are mounted on a circuit board in a side by side layout, or a double-layered structure is formed by mounting a plurality of semiconductor packages on two opposite sides of a circuit board. However, no matter it is a side by side layout or a double-layered layout, a great deal of space and volume of the circuit board is taken, and the space of the circuit board required for incorporating the semiconductor packages should be increased to cope with an increasing number of the semiconductor packages.

In order to overcome the abovementioned space-inefficiency drawback, a multi-chip module has been wildly applied to the semiconductor package structure in recently years, wherein two or more chips are stacked up or laid side by side, and are integrated into a single package structure, thereby reducing the overall size of circuit structure of an electronic product, enhancing electrical performance, and providing a thin and light multi-chip modular package at low cost. For instances, according to U.S. Patent Nos. 6,791,178, 5,994,166, 5,323,060 and 6,051,878, package structures, including side by side layout, stacked layout, and combination of both layouts, are disclosed. However, a major disadvantage of the multi-chip module relates to failure in ensuring the use of known good dies (KGDs), which makes the cost of multi-chip module package structure difficult to reduce.

Accordingly, U.S. Patent No. 6,798,054 provides an improved multi-chip module package structure, wherein semiconductor packages that have passed test, namely having known good dies (KGDs), are combined and integrated with other chips into a single semiconductor device.

In addition, in order to increase memory capacity of a memory module, e.g. flash memory, the number of the above stacked semiconductor packages must be increased accordingly. Related prior arts include U.S. Patent Nos. 5,247,423, 6,225,689, 6,190,944 and 4,996,587, wherein a plurality of semiconductor packages are vertically stacked and are electrically connected to one another by means of pin to pin parallel connection, namely, one-channel stacking. Although the one-channel stacked memory module has increased memory chip capacity, problems of low transmission speed and low efficiency of the memory module are encountered.

In view of the above drawbacks, a multi-channel module structure has been proposed by U.S. Patent Nos. 4,996,583 and 5,677,569. According to U.S. Patent No. 4,996,583, tape automated bonding, TAB, is applied in the packaging process, which however makes the fabrication processes complicated and requires expensive tapes. According to U.S. Patent No. 5,677,569, another special packaging method is adopted but it has high cost. Thus, both the packaging techniques are not able to effectively solve the existing problems.

Therefore, the problem to be solved here is to provide a multi-channel stackable semiconductor device and a method for fabricating the same, which can effectively solve the drawbacks in the prior art as mentioned above.

### SUMMARY OF THE INVENTION

In view of the disadvantages of the prior art mentioned above, it is an objective of the present invention to provide a multi-channel stackable semiconductor device and a method for fabricating the same, and a stacking substrate applied to the semiconductor device, which are capable of using universal package members having known good dies.

It is another objective of the present invention to provide a multi-channel stackable semiconductor device and a method for fabricating the same, and a stacking substrate applied to the semiconductor device, which are capable of using universal package members having know good dies and stacking the universal package members.

It is still another objective of the present invention to provide a multi-channel stackable semiconductor device and a method for fabricating the same, and a stacking substrate applied to the semiconductor device, which are capable of performing the fabrication processes without needing specially made package members.

It is a further objective of the present invention to provide a multi-channel stackable semiconductor device and a method for fabricating the same, and a stacking substrate applied to the semiconductor device, which do not require expensive or complicatedly fabricated package members.

It is a further objective of the present invention to provide a multi-channel stackable semiconductor device and a method for fabricating the same, and a stacking substrate applied to the semiconductor device, which can reduce the fabrication cost and increase the yield.

It is a further objective of the present invention to provide a multi-channel stackable semiconductor device and a method for fabricating the same, and a stacking substrate applied to the semiconductor device, which can avoid using expensive materials and also simplify the fabrication processes.

It is a further objective of the present invention to provide a multi-channel stackable semiconductor device and a method for fabricating the same, and a stacking substrate applied to the semiconductor device, which can enhance the transmission speed and efficiency.

To achieve the aforementioned and other objectives, a multi-channel stackable semiconductor device is provided according to the present invention. The multi-channel stackable semiconductor device comprises: a modular circuit board; a plurality of stacking substrates each comprising a first surface, a second surface opposite to the first surface, a plurality of electrical bond pads and ball pads formed on the first surface, and a plurality of electrical terminals formed on the second surface, wherein the ball pads are electrically connected to the electrical terminals by conductive structures formed in each of the stacking substrates, and a plurality of corresponding connection paths are provided between at least one of the electrical bond pads and at least some of the ball pads, so as to allow each of the electrical bond pads to be selectively electrically connected to the ball pads; and a plurality of package members having known good dies, each of the package members being mounted on a corresponding one of the stacking substrates and being electrically connected to the electrical bond pads of the corresponding one of the stacking substrates, wherein the stacking substrates with the package members mounted thereon are stacked and electrically connected to the modular circuit board, and adjacent ones of the stacked stacking substrates are electrically interconnected by solder balls bonded to the ball pads of an overlying one of the stacking substrates and to the electrical terminals of an underlying one of the stacking substrates.

According to the above structure, each of the stacking substrates comprises conductive vias for electrically connecting the ball pads on the first surface to the electrical terminals on the second surface. The electrical bond pads of each of the stacking substrates can be selectively electrically connected to the ball pads by conductive traces or passive components with nearly zero resistance. Each of the stacking substrates can be formed with an opening for receiving a corresponding one of the package members. Each of the package members can be a thin small outline package (TSOP) or a thin and fine-pitch ball grid array (TFBGA) structure.

The present invention also provides a fabrication method of a multi-channel stackable semiconductor device, comprising the steps of: providing a plurality of stacking substrates, each of the stacking substrates comprising a first surface, a second surface opposite to the first surface, a plurality of electrical bond pads and ball pads formed on the first surface, and a plurality of electrical terminals formed on the second surface, wherein the ball pads are electrically connected to the electrical terminals by conductive structures formed in each of the stacking substrates, and a plurality of corresponding connection paths are provided between at least one of the electrical bond pads and at least some of the ball pads; mounting a plurality of package members having known good dies on the stacking substrates respectively and electrically connecting each of the package members to the electrical bond pads of a corresponding one of the stacking substrates, and implanting solder balls on the ball pads of the stacking substrates; determining electrical connections to be formed between the electrical bond pads and the ball pads of each of the stacking substrates, so as to allow each of the electrical bond pads to be selectively electrically connected to the ball pads; and stacking the stacking substrates with the package members mounted thereon, and electrically connecting the stacked stacking substrates to a modular circuit board, wherein adjacent ones of the stacked stacking substrates are electrically interconnected by bonding the solder balls on the ball pads of an overlying one of the stacking substrates to the electrical terminals of an underlying one of the stacking substrates.

According to the above fabrication method, the electrical bond pads of each of the stacking substrates are electrically connected to the ball pads by conductive traces initially, and then a laser trim process is performed to cut off the electrical connections between the electrical bond pads and the ball pads partially, so as to allow each of the electrical bond pads to be selectively electrically connected to predetermined corresponding ones of the ball pads. Alternatively, the electrical bond pads of each of the stacking substrates are free of being electrically connected to the balls pads initially, and each of the electrical bond pads is selectively electrically connected to predetermined corresponding ones of the ball pads by passive components with nearly zero resistance, depending on a stacking position of each of the stacking substrates in relation to the other stacking substrates.

The present invention further provides a semiconductor device, comprising: a stacking substrate comprising a first surface, a second surface opposite to the first surface, a plurality of electrical bond pads and ball pads formed on the first surface, and a plurality of electrical terminals formed on the second surface, wherein the ball pads are electrically connected to the electrical terminals by conductive structures formed in the stacking substrate, and a plurality of corresponding connection paths are provided between at least one of the electrical bond pads and at least some of the ball pads, so as to allow each of the electrical bond pads to be selectively electrically connected to the ball pads; and a package member having a know good die, the package member being mounted on the stacking substrate and electrically connected to the electrical bond pads of the stacking substrate.

The present invention further provides a stacking substrate, comprising: a substrate body having a first surface and a second surface opposite to the first surface; a plurality of electrical bond pads and ball pads formed on the first surface of the substrate body, wherein a plurality of corresponding connection paths are provided between at least one of the electrical bond pads and at least some of the ball pads, so as to allow each of the electrical bond pads to be selectively electrically connected to the ball pads; and a plurality of electrical terminals formed on the second surface of the substrate body, wherein the ball pads are electrically connected to the electrical terminals by conductive structures formed in the substrate body.

Therefore, according to the multi-channel stackable semiconductor device and the method for fabricating the same in the present invention, a plurality of stacking substrates and package members having known good dies are provided. Each of the stacking substrates comprises a first surface, a second surface opposite to the first surface, a plurality of electrical bond pads and ball pads formed on the first surface, and a plurality of electrical terminals formed on the second surface. The ball pads are electrically connected to the electrical terminals by conductive structures formed in each of the stacking substrates, and a plurality of corresponding connection paths are provided between at least one of the electrical bond pads and at least some of the ball pads, so as to allow each of the electrical bond pads to be selectively electrically connected to the ball pads. Each of the package members is mounted on a corresponding one of the stacking substrates and is electrically connected to the electrical bond pads of the corresponding one of the stacking substrates. The stacking substrates with the package members mounted thereon are stacked and electrically connected to the modular circuit board, wherein adjacent ones of the stacked stacking substrates are electrically interconnected by solder balls bonded to the ball pads of an overlying one of the stacking substrates and to the electrical terminals of an underlying one of the stacking substrates. Thereby, the package members, such as flash memories, can be stacked up on the modular circuit board directly, avoiding the side by side layout that takes up too much space on the circuit board as in the prior art, while providing multi-channel electrical connection outlets so as to enhance the operational and processing speed of the memories. Furthermore, the present invention adopts package members having known good dies, thereby improving the yield, and without needing specially made package members, expensive tapes or complicated processes, thereby decreasing the cost and simplifying the fabrication processes.

### BRIEF DESCRIPTION OF DRAWINGS

The present invention can be more fully understood by reading the following detailed description of the preferred embodiments, with reference made to the accompanying drawings, wherein:
FIGS. 1A through 1C are schematic diagrams of a stacking substrate according to the present invention;
FIG. 2 is a schematic diagram of a semiconductor device comprising a package member having a known good die and mounted on a stacking substrate according to the present invention;
FIGS. 3A through 3D are schematic diagrams showing predetermined connection between electrical bond pads and ball pads of the stacking substrate according to a stacking position thereof;
FIGS. 4A and 4B are schematic diagrams showing stacking of the stacking substrates that are mounted with package members;
FIGS. 5A through 5D are schematic diagrams of the stacking substrate according to a second embodiment of the present invention;
FIGS. 6A and 6B are schematic diagrams of a semiconductor device and a multi-channel stackable semiconductor device according to a third embodiment of the present invention; and
FIG. 7 is a schematic diagram of the multi-channel stackable semiconductor device according to a fourth embodiment of the present invention.

### DETAILED DESCRIPTION OF PREFERRED EMBODIMENTS

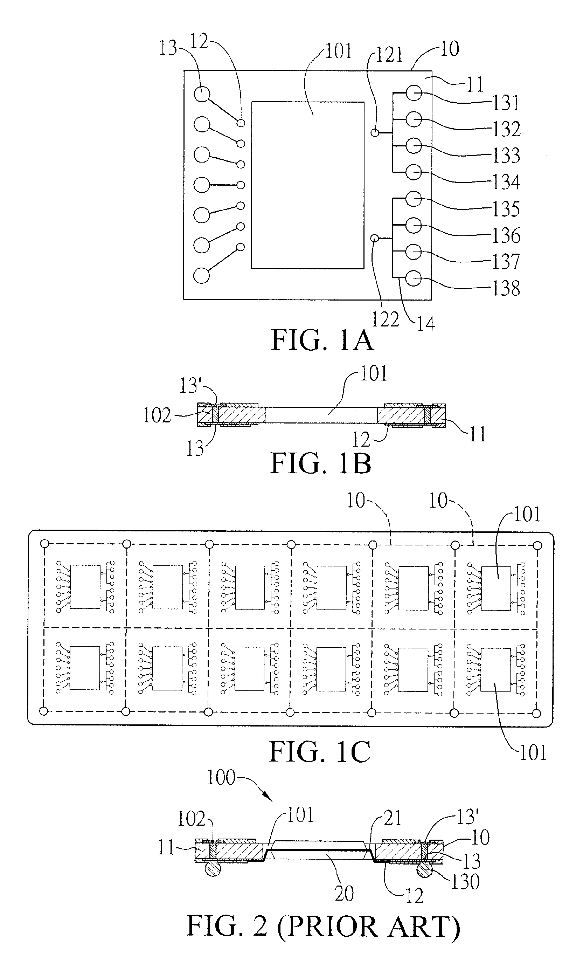

Preferred embodiments of a multi-channel stackable semiconductor device and a method for fabricating the same, and a stacking substrate applied to the semiconductor device as proposed by the present invention are described in detail as follows with reference to FIGS. 1 through 7. It should be understood that the drawings are simplified schematic diagrams only showing the components relevant to the present invention, and the layout of components could be more complicated in practical implementation.

### FIRST EMBODIMENT

FIGS. 1A through 1C, FIGS. 2A through 2D, FIG. 3, and FIGS. 4A and 4B are schematic diagrams of a multi-channel stackable semiconductor device and a method for fabricating the same and a stacking substrate applied to the semiconductor device according to first embodiment of the present invention.

As shown in FIGS. 1A through 1C, first, a plurality of stacking substrates 10, which have the same appearance and specification, are provided, each comprising a substrate body 11, a first surface, and a second surface opposite to the first surface. An opening 101 is formed in the substrate body 11. A plurality of electrical bond pads 12 and a plurality of ball pads 13 are formed on the first surface of the stacking substrate 10, wherein the electrical bond pads 12 are electrically connected to the ball pads 13 by conductive traces 14. A plurality of electrical terminals 13' are provided on the second surface of each of the stacking substrate 10. Each of the stacking substrates 10 is also formed with conductive structures (such as conductive vias) therein for electrically connecting the ball pads 13 on the first surface to the electrical terminals 13' on the second surface. The stacking substrates 10 can be singular substrates, or can be arranged in an array (FIG. 1C) for batch production, thereby ready for a plurality of package members having known good dies (which have passed a function test) and for subsequent surface mount and laser trim processes, to be described later on.

A plurality of corresponding connection paths are provided between the singular electrical bond pads and the plurality of ball pads on one side of the stacking substrate, so as to allow the electrical bond pads to be selectively electrically connected to the corresponding ball pads. As shown in FIG. 1A, in this embodiment, for example (but not limited to), an electrical bond pad 121 is provided with selective connection to four ball pads 131, 132, 133 and 134, and another electrical bond pad 122 is also provided with selective connection to four ball pads 135, 136, 137 and 138.

As shown in FIG. 2, a package member 20, which incorporates a known good die that has passed the function test, is received in the opening 101 of one of the stacking substrates 10, and is electrically connected to the electrical bond pads 12 of the stacking substrate 10, and a plurality of solder balls 130 are implanted to the ball pads 13 of the stacking substrate 10, thereby forming a semiconductor device 100. In this embodiment, the package member 20 can be a thin small outline package (TSOP), e.g. a flash memory, and is electrically connected to the electrical bond pads 12 of the stacking substrate 10 by leads 21. Alternatively, in practice, the package member 20 can be a thin and fine-pitch ball grid array (TFBGA) structure or any other package structure. Accordingly, by the same arrangement, each of the plurality of stacking substrates 10 is mounted with a package member 20.

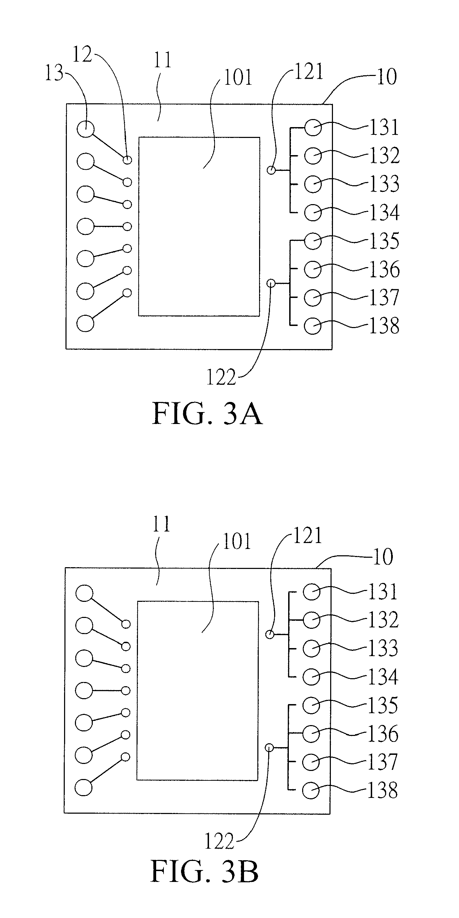

As shown in FIGS. 3A through 3D, according to a stacking position of a stacking substrate 10, conductive traces for predetermined connection between the electrical bond pads 12 and the ball pads 13 on the stacking substrate 10 are determined and retained, and the remaining conductive traces not for the predetermined connection are cut off.

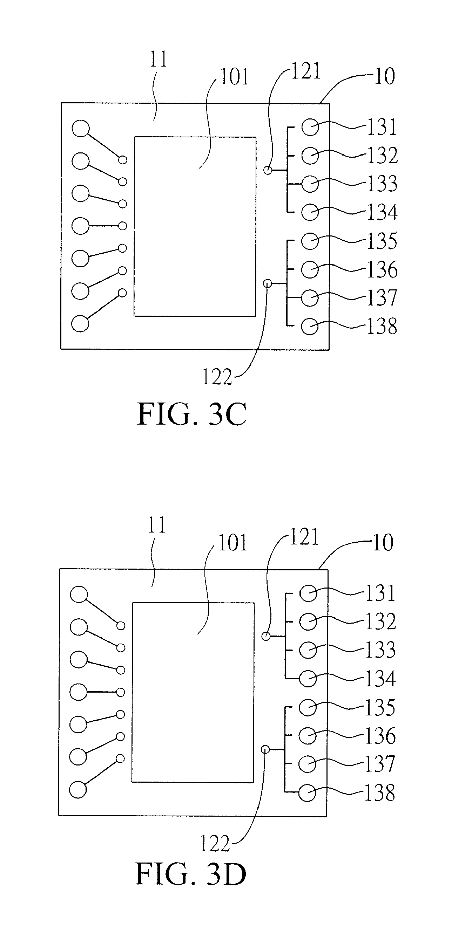

In this embodiment, for example (but not limited to), stacking of four stacking substrates 10 mounted with package members 20 to form a multi-channel stackable semiconductor device is illustrated. For the stacking substrate 10 shown in FIG. 3A, it is determined that the electrical bond pad 121 is electrically connected to the ball pad 131, and the electrical bond pad 122 is electrically connected to the ball pad 135, such that a laser trim process is performed to cut off the connection paths between the electrical bond pad 121 and the ball pads 132, 133 and 134 and between the electrical bond pad 122 and the ball pads 136, 137 and 138. For the stacking substrate 10 shown in FIG. 3B, it is determined that the electrical bond pad 121 is electrically connected to the ball pad 132, and the electrical bond pad 122 is electrically connected to the ball pad 136. For the stacking substrate 10 shown in FIG. 3C, the electrical bond pad 121 is electrically connected to the ball pad 133, and the electrical bond pad 122 is electrically connected to the ball pad 137. For the stacking substrate 10 shown in FIG 3D, it is determined that the electrical bond pad 121 is electrically connected to the ball pad 134, and the electrical bond pad 122 is electrically connected to the ball pad 138.

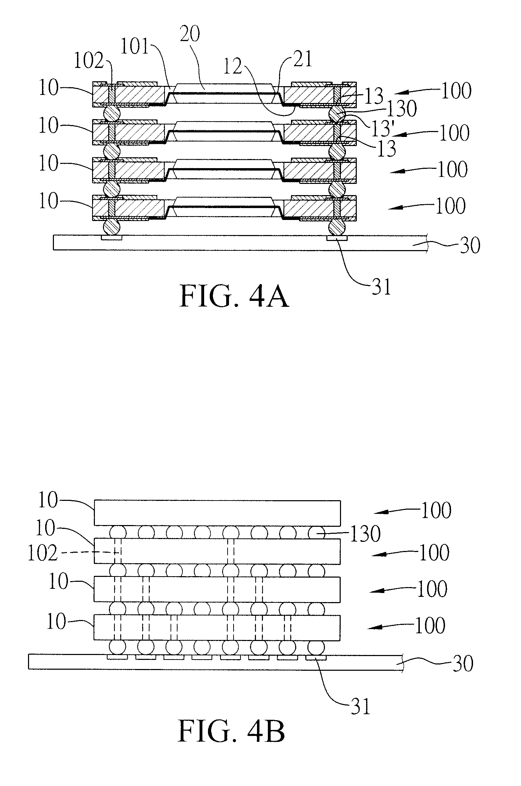

As shown in FIGS. 4A and 4B, the semiconductor devices 100, each comprising a stacking substrate 10 mounted with a package member, are stacked up (in this embodiment, there are four layers of semiconductor devices stacked up). The stacking substrates 10 of the semiconductor devices 100 are stacked up and are electrically connected to a modular circuit board 30, wherein an overlying stacking substrate 10 is electrically connected via the solder balls 130 on the ball pads 13 thereof to the electrical terminals 13' of an underlying stacking substrate 10. The modular circuit board 30 is provided with electrical bond pads 31 on a surface thereof, such that the lowermost stacking substrate 10 can be electrically connected via the solder balls 130 to the electrical bond pads 31 of the modular circuit board 30. This thereby completes the multi-channel stackable semiconductor device of the present invention, which comprises a plurality of stacking substrates 10 (each being mounted with a package member 20) stacked up and electrically connected to the modular circuit board 30.

Accordingly, the present invention allows the package members, e.g. flash memories, to be stacked on the circuit board directly, avoiding the side by side layout that takes up much space on the circuit board as in the prior art, while providing multi-channel electrical connection outlets (as shown in FIG. 4B) and thereby enhancing the operational and processing speed of the memories.

The present invention further discloses a multi-channel stackable semiconductor device, which comprises: a modular circuit board 30; a plurality of stacking substrate 10 each comprising a first surface, a second surface opposite to the first surface, a plurality of electrical bond pads 12 and ball pads 13 formed on the first surface, and a plurality of electrical terminals 13' formed on the second surface, wherein the ball pads 13 are electrically connected to the electrical terminals 13' by conductive structures formed in the stacking substrate 10, and a plurality of corresponding connection paths are provided between singular the electrical bond pads 12 and the plurality of ball pads 13, so as to allow each of the electrical bond pads 12 to be selectively electrically connected to the ball pads 13; and a plurality of package members 20 having known good dies, each of the package members 20 being mounted on a corresponding one of the stacking substrates 10 and being electrically connected to the electrical bond pads 12 of the corresponding stacking substrate 10, wherein the stacking substrates 10 mounted with the package members 20 are stacked up and are electrically connected to the modular circuit board 30, wherein an overlying stacking substrate 10 is electrically connected via the solder balls 130 on the ball pads 13 thereof to the electrical terminals 13' of an underlying the stacking substrate 10.

The present invention further provides a stacking substrate 10, comprising: a substrate body 11 having a first surface and a second surface opposite to the first surface; a plurality of electrical bond pads 12 and a plurality of ball pads 13, which are formed on the first surface of the substrate body 11, wherein a plurality of corresponding connection paths are provided between singular electrical bond pads 12 and the plurality of ball pads 13, so as to allow each of the electrical bond pads 12 to be selectively electrically connected to the ball pads 13; and a plurality of electrical terminals 13' formed on the second surface of the substrate body 11, wherein the ball pads 13 are electrically connected to the electrical terminals 13' by conductive structures formed within the stacking substrate 10.

The present invention further provides a semiconductor device 100, comprising: a stacking substrate 10, which comprises a first surface, a second surface opposite to the first surface, a plurality of electrical bond pads 12 and ball pads 13 formed on the first surface, and a plurality of electrical terminals 13' formed on the second surface, wherein the ball pads 13 are electrically connected to the electrical terminals 13' by conductive structures formed in the stacking substrate 10, and a plurality of corresponding connection paths are provided between singular electrical bond pads 12 and the plurality of ball pads 13, so as to allow each of the electrical bond pads 12 to be selectively electrically connected to the ball pads 13; and a package member 20 having a known good die, wherein the package member 20 is mounted on and electrically connected to the electrical bond pads 12 of the stacking substrate 10.

### SECOND EMBODIMENT

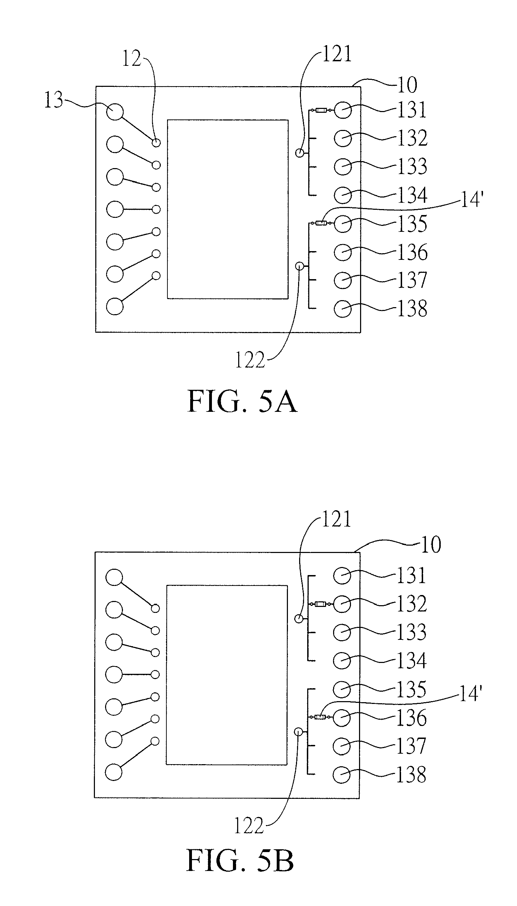

FIGS. 5A through 5D are schematic diagrams of the stacking substrate according to the second embodiment of the present invention. This embodiment is similar to the first embodiment, with a difference in that, for the stacking substrate in this embodiment, a conductor is used to selectively electrically connect the electrical bond pads to the corresponding ball pads.

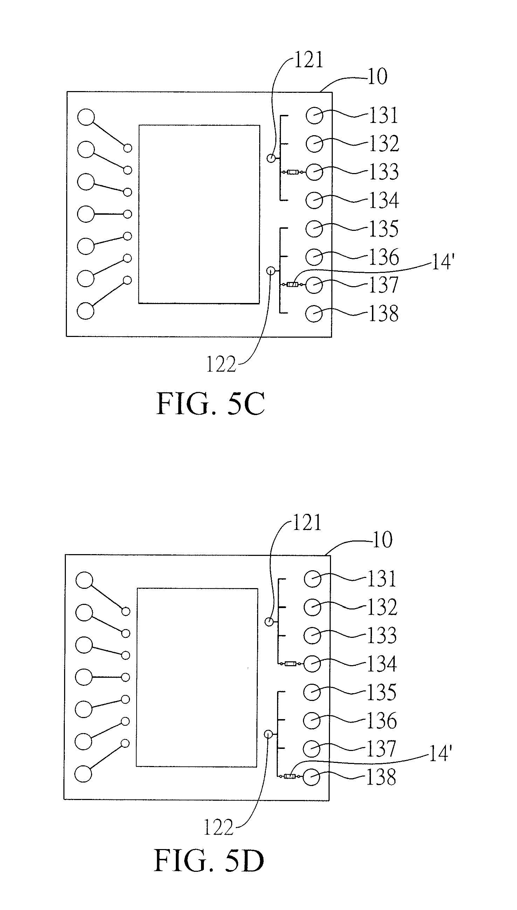

The electrical bond pads 121 and 122 on the stacking substrate 10 initially are not electrically connected to the corresponding ball pads 131, 132, 133 and 134 and the corresponding ball pads 135, 136, 137 and 138 respectively. According to a stacking position of the stacking substrate 10 in relation to other stacking structures to be stacked thereto (for example, the stacking structure shown in FIG. 4A, 4B, 6B or 7), a conductor 14', such as a passive component with nearly zero resistance, is bonded to the stacking substrate 10, for selectively electrically connecting the electrical bond pads 121 and 122, is soldered onto each the stacking substrate to allow each of the electrical bond pads to the corresponding ball pads. For a stacking substrate 10 shown in FIG. 5A, it is determined that the electrical bond pad 121 is electrically connected to the ball pad 131, and the electrical bond pad 122 is electrically connected to the ball pad 135. The respective electrical connection is established by a conductor 14' (such as a passive component with nearly zero resistance). For another stacking substrate 10 shown in FIG. 5B, the electrical bond pad 121 is electrically connected to the ball pad 132, and the electrical bond 122 is electrically connected to the ball pad 136. The respective electrical connection is established by a passive component with zero resistance. For a further stacking substrate 10 shown in FIG. 5C, the electrical bond pad 121 is electrically connected to the ball pad 133, and the electrical bond 122 is electrically connected to the ball pad 137. The respective electrical connection is established by a passive component with zero resistance. For a further stacking substrate 10 shown in FIG. 5D, the electrical bond pad 121 is electrically connected to the ball pad 134, and the electrical bond 122 is electrically connected to the ball pad 138. The respective electrical connection is established by a passive component with zero resistance.

### THIRD EMBODIMENT

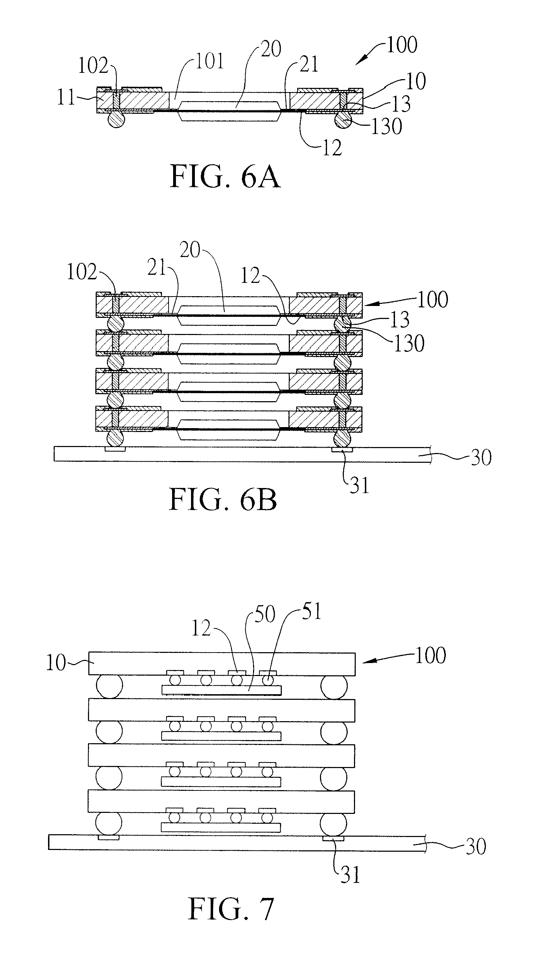

FIGS. 6A and 6B are sectional diagrams of the semiconductor device and the multi-channel stackable semiconductor device according to a third embodiment of the present invention. This embodiment is similar to the above embodiments, with a difference in that, in the semiconductor device 100 of this embodiment, outer portions of the leads 21 of the package member 20 (e.g. a TSOP) are trimmed or cut away to have the leads 21 flatly attached to the first surface of the stacking substrate 10 formed with the ball pads 13, so as to reduce the overall stacking height of the multi-channel stackable semiconductor device.

### FOURTH EMBODIMENT

FIG. 7 is a schematic diagram of the multi-channel stackable semiconductor device according to a fourth embodiment of the present invention. This embodiment is similar to the above embodiments, with a difference in that, the stacking substrates 10 are not formed with openings for receiving package members in this embodiment, while a package member 50 is attached to each of the stacking substrates 10 and can be a thin and fine-pitch ball grid array (TFBGA) structure, and solder balls 51 are used to electrically connect the package member 50 to the electrical bond pads 12 of the corresponding stacking substrate 10.

Therefore, according to the multi-channel stackable semiconductor device and the method for fabricating the same in the present invention, a plurality of stacking substrates and package members having known good dies are provided. Each of the stacking substrates comprises a first surface, a second surface opposite to the first surface, a plurality of electrical bond pads and ball pads formed on the first surface, and a plurality of electrical terminals formed on the second surface. The ball pads are electrically connected to the electrical terminals by conductive structures formed in each of the stacking substrates, and a plurality of corresponding connection paths are provided between at least one of the electrical bond pads and at least some of the ball pads, so as to allow each of the electrical bond pads to be selectively electrically connected to the ball pads. Each of the package members is mounted on a corresponding one of the stacking substrates and is electrically connected to the electrical bond pads of the corresponding one of the stacking substrates. The stacking substrates with the package members mounted thereon are stacked and electrically connected to the modular circuit board, wherein adjacent ones of the stacked stacking substrates are electrically interconnected by solder balls bonded to the ball pads of an overlying one of the stacking substrates and to the electrical terminals of an underlying one of the stacking substrates. Thereby, the package members, such as flash memories, can be stacked up on the modular circuit board directly, avoiding the side by side layout that takes up too much space on the circuit board as in the prior art, while providing multi-channel electrical connection outlets so as to enhance the operational and processing speed of the memories. Furthermore, the present invention adopts package members having known good dies, thereby improving the yield, and without needing specially made package members, expensive tapes or complicated processes, thereby decreasing the cost and simplifying the fabrication processes.

## Claims

1. A stacking substrate, comprising:
a substrate body having a first surface and a second surface opposite to the first surface;
a plurality of electrical bond pads and ball pads formed on the first surface of the substrate body, wherein a plurality of corresponding connection paths are provided between at least one of the electrical bond pads and at least some of the ball pads, so as to allow each of the electrical bond pads to be selectively electrically connected to the ball pads; and
a plurality of electrical terminals formed on the second surface of the substrate body, wherein the ball pads are electrically connected to the electrical terminals by conductive structures formed in the substrate body.

2. The stacking substrate of claim 1, wherein the electrical bond pads are electrically connected to the ball pads by conductive traces, the electrical connections between the electrical bond pads and the ball pads preferably being laser trimmed off partially so as to allow each of the electrical bond pads to be selectively electrically connected to predetermined corresponding ones of the ball pads.

3. The stacking substrate of claim 1, wherein each of the electrical bond pads is selectively electrically connected to predetermined corresponding ones of the ball pads by passive components with nearly zero resistance, preferably depending on a stacking position of the stacking substrate in relation to other stacking substrates to be stacked thereto.

4. The stacking substrate of any of the preceding claims, wherein the electrical bond pads of the stacking substrate are for allowing a package member having a known good die to be mounted and electrically connected thereto, for example a thin small outline package (TSOP), electrically connected to the electrical bond pads of the stacking substrate by leads, wherein preferably outer portions of the leads of the package member are trimmed so as to allow the leads to be flatly attached to the first surface of the substrate body.

5. The stacking substrate of claim 4, wherein the package member is a thin and fine-pitch ball grid array (TFBGA) structure, and is electrically connected to the electrical bond pads of the stacking substrate by solder balls.

6. The stacking substrate of any of the preceding claims, wherein the stacking substrate is formed with an opening for receiving the package member.

7. A semiconductor device, comprising:
a stacking substrate according to any of the preceding claims; and
a package member having a know good die, the package member being mounted on the stacking substrate and electrically connected to the electrical bond pads of the stacking substrate.

8. The semiconductor device of claim 7, further comprising a plurality of solder balls implanted on the ball pads.

9. A multi-channel stackable semiconductor device, comprising:
a modular circuit board;
a plurality of stacking substrates according to any of claims 1 to 6; and
a plurality of package members having known good dies, each of the package members being mounted on a corresponding one of the stacking substrates and being electrically connected to the electrical bond pads of the corresponding one of the stacking substrates, wherein the stacking substrates with the package members mounted thereon are stacked and electrically connected to the modular circuit board, and adjacent ones of the stacked stacking substrates are electrically interconnected by solder balls bonded to the ball pads of an overlying one of the stacking substrates and to the electrical terminals of an underlying one of the stacking substrates.

10. A method for fabricating a multi-channel stackable semiconductor device, comprising the steps of:
providing a plurality of stacking substrates, each of the stacking substrates comprising a first surface, a second surface opposite to the first surface, a plurality of electrical bond pads and ball pads formed on the first surface, and a plurality of electrical terminals formed on the second surface, wherein the ball pads are electrically connected to the electrical terminals by conductive structures formed in each of the stacking substrates, and a plurality of corresponding connection paths are provided between at least one of the electrical bond pads and at least some of the ball pads;
mounting a plurality of package members having known good dies on the stacking substrates respectively and electrically connecting each of the package members to the electrical bond pads of a corresponding one of the stacking substrates, and implanting solder balls on the ball pads of the stacking substrates;
determining electrical connections to be formed between the electrical bond pads and the ball pads of each of the stacking substrates, so as to allow each of the electrical bond pads to be selectively electrically connected to the ball pads; and
stacking the stacking substrates with the package members mounted thereon, and electrically connecting the stacked stacking substrates to a modular circuit board, wherein adjacent ones of the stacked stacking substrates are electrically interconnected by bonding the solder balls on the ball pads of an overlying one of the stacking substrates to the electrical terminals of an underlying one of the stacking substrates.

11. The method of claim 10, wherein the electrical bond pads of each of the stacking substrates are electrically connected to the ball pads by conductive traces or passive components with nearly zero resistance.

12. The method of claim 10, wherein the electrical bond pads of each of the stacking substrates are electrically connected to the ball pads by conductive traces initially, and then a laser trim process is performed to cut off the electrical connections between the electrical bond pads and the ball pads partially, so as to allow each of the electrical bond pads to be selectively electrically connected to predetermined corresponding ones of the ball pads.

13. The method of claim 10, wherein the electrical bond pads of each of the stacking substrates are free of being electrically connected to the balls pads initially, and each of the electrical bond pads is selectively electrically connected to predetermined corresponding ones of the ball pads by passive components with nearly zero resistance, depending on a stacking position of each of the stacking substrates in relation to the other stacking substrates.

14. The method of any of claims 10 to 13, wherein each of the package members is a thin small outline package (TSOP), and is electrically connected to the electrical bond pads of the corresponding one of the stacking substrates by leads, and wherein preferably outer portions of the leads of each of the package members are trimmed so as to allow the leads to be flatly attached to the first surface of the corresponding one of the stacking substrates.

15. The method of any of claims 10 to 13, wherein each of the package members is a thin and fine-pitch ball grid array (TFBGA) structure, and is electrically connected to the electrical bond pads of the corresponding one of the stacking substrates by solder balls.

16. The method of any of claims 10 to 15, wherein each of the stacking substrates is formed with an opening for receiving a corresponding one of the package members.
